# EUROPEAN PATENT APPLICATION

(11) **EP 4 632 347 A1**
(43) Date of publication of application: **15.10.2025**
(21) Application number: 24904119.5
(22) Date of filing: 29.11.2024
(51) Int. Cl.: G01N 3/04, G01N 3/08, G01D 11/16, H01M 10/42

(54) **PENETRATION TEST APPARATUS INCLUDING ZERO-POINT ADJUSTMENT APPARATUS AND PENETRATION TEST METHOD USING SAME**

(30) Priority: 12.12.2023 KR 20230180150
(71) Applicant: LG Energy Solution, Ltd., Seoul 07335 (KR)
(72) Inventor: SON, Hye Bin, Daejeon 34122 (KR)
(74) Representative: Goddar, Heinz J.
(86) International application number: PCT/KR2024/019394
(87) International publication number: WO 2025/127554

(57) **Abstract**

Disclosed are a penetration test apparatus including an upper surface pressing plate configured to press an upper surface of a battery cell, a lower surface pressing plate configured to press a lower surface of the battery cell, a through-hole in the upper surface pressing plate, a nail configured to penetrate the battery cell through the through-hole, and a zero-point adjustment unit protruding outward from an outer periphery of a side of the upper surface pressing plate and a penetration test method using the same, wherein it is possible to accurately set the zero point, which is a reference point for the position where the nail is inserted.

## Description

### [Technical Field]

This application claims the benefit of priority to Korean Patent Application No. 2023-0180150 filed on December 12, 2023, the disclosure of which is incorporated herein by reference in its entirety.

The present invention relates to a penetration test apparatus including a zero-point adjustment device and a penetration test method using the same. More particularly, the present invention relates to a penetration test apparatus including a zero-point adjustment device for setting the zero-point position of a nail during a penetration test of a pouch-shaped battery cell and a penetration test method using the same.

### [Background Art]

Explosion of lithium secondary batteries may have serious consequences for the lives of users, and therefore safety evaluation tests are essential. Internal short circuit, overcharging, and overdischarging are the main factors affecting the stability of lithium secondary batteries. In particular, a penetration test, which is used to identify the effects due to internal short circuit, is treated as the most important evaluation test.

The penetration test is a method of observing whether fire or explosion occurs by penetrating a battery cell using a nail (nail), which is a needle-shaped conductor having a pointed end made of metal, or by pressing the nail into the battery cell to a certain depth to induce short circuit in the battery. The insertion depth of the nail inserted from the surface of the battery cell into the battery cell is quantified to a certain numerical value, and ignition or explosion is checked when the nail is inserted to the insertion depth. However, it is not easy to accurately measure the depth of the nail inserted through a through-hole formed in the center of a plate-shaped member.

Patent Document 1 discloses a pressing-in test apparatus configured such that a zero-point auxiliary jig having a reference height is disposed between an upper surface of a battery and a nail, a pointed part of the nail is moved to an upper end of the zero-point auxiliary jig disposed on the battery to measure the position of the nail, the reference height is compensated at the measured position to set the value of the zero point, and the pointed part of the nail is located on the surface of the battery using the value of the zero point during a pressing-in test.

In Patent Document 1, the battery is inserted into and fixed in a test jig formed as a box structure having a certain space defined therein, and the pressing-in test is performed. If a pouch-shaped battery cell is not pressed with a certain amount of force, a battery case and an electrode assembly may not be in tight contact with each other. This may cause a difference between the depth to which the nail is inserted and a set depth.

In Patent Document 1, a prismatic battery having a metal case is used, wherein the prismatic battery is not easily deformed, unlike a pouch-shaped battery, and therefore the jig does not press the battery at more than a certain pressure. In Patent Document 1, the zero-point auxiliary jig configured to determine the position of the zero point is a cylindrical object, and when the zero-point auxiliary jig is used for a pouch-shaped battery, a problem may occur if a laminate sheet of the pouch-shaped battery is not completely flat.

Patent Document 2 relates to a solid-state battery cell penetration test apparatus including a pressing part configured to press a battery cell, a penetrating member configured to penetrate the battery cell through a through-hole formed in the pressing part, and an auxiliary pressing part disposed between the pressing part and the battery cell, the auxiliary pressing part being configured to transmit the pressure applied by the pressing part to the battery cell, wherein the auxiliary pressing part is disposed between the through-hole and the battery cell so as to block the through-hole.

Patent Document 2 is difficult to use for a penetration test to cause internal short circuit because the auxiliary pressing part blocks the through-hole in the pressing part, making it difficult for the penetrating member to be inserted into the battery cell.

Measurement of the voltage in Patent Document 2 is measurement of the voltage between a positive electrode terminal of the battery undergoing the penetration test and the nail, which is performed to identify the characteristics of a penetration step, unlike measuring the exact position of the zero point in the present invention.

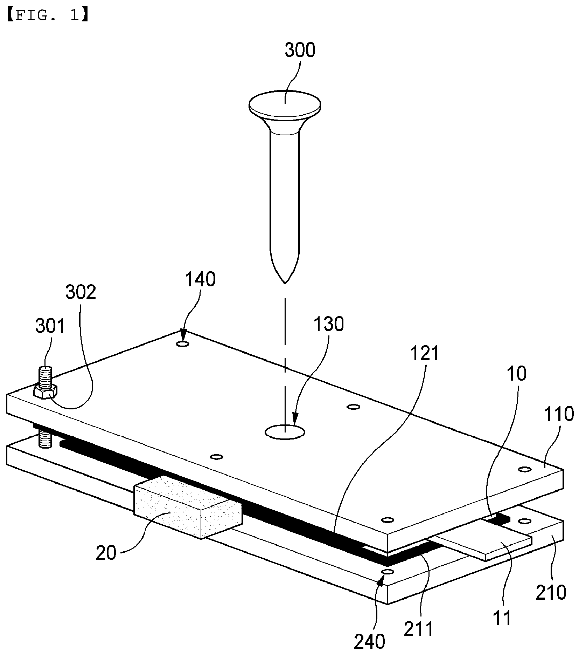

FIG. 1 is a perspective view of a conventional penetration test apparatus, which is a penetration test apparatus for artificially causing internal short circuit.

Referring to FIG. 1, the penetration test apparatus includes an upper surface pressing plate 110 disposed on an upper surface of a battery cell 10, a lower surface pressing plate 210 disposed on a lower surface of the battery cell 10, and a nail 300 configured to penetrate the battery cell 10. The battery cell 10 is fixed in a state of being pressed at a predetermined pressure by the upper surface pressing plate 110 and the lower surface pressing plate 210, and a through-hole 130, though which a nail passes, is formed in the center of the upper surface pressing plate 110. An insulating film 111 configured to prevent short circuit in the battery cell 10 is attached to each of a lower surface of the upper surface pressing plate 110 and an upper surface of the lower surface pressing plate 210.

The nail 300 is inserted into the through-hole 130, and therefore it is difficult for a worker to check the zero point, which is the position where the nail 300 is in contact with the surface of the battery cell 10 and is the reference for the insertion depth.

In order to solve this problem, a method of inserting a plastic hexahedron 20 having a thickness equal to the thickness of the battery cell 10 or less than the thickness of the battery cell 10 between the upper surface pressing plate 110 and the lower surface pressing plate 210 and bringing the nail 300 into contact with an upper surface of the plastic hexahedron 20 to set the zero point is used. The plastic hexahedron 20 has a non-flat surface, and the position where the nail 300 is determined to be in contact with the surface of the plastic hexahedron 20 is set as the zero point based on the worker's eyes and senses, and therefore the criterion of the zero point may vary depending on the worker.

The insulating film 111 is attached to the lower surface of the upper surface pressing plate 110. If the insulating film 111 is not attached to the position where the plastic hexahedron 20 is interposed, the height of the plastic hexahedron 20 does not include the thickness of the insulating film 111, resulting in a deviation equivalent to the thickness of the insulating film 111.

As an example, a test to penetrate a battery cell to 2.2 mm from the surface of the battery cell may be conducted, or a test to penetrate 3 to 5 sets of monocells of an electrode assembly in a battery cell may be conducted. In this case, if a conventional method or the method of Patent Document 1 is used, the plastic hexahedron 20 is not aligned properly, the error due to the thickness of the insulating film 111 is not considered, or the uneven surface of the pouch-shaped battery cell case does not allow for accurate testing. If a conventional penetration test apparatus is used on site, and there is the problem that products may or may not be determined to be defective depending on a tester who conducts an actual test.

Consequently, there is a need for technology capable of setting the zero point such that a penetration test can be conducted for a battery cell in tight contact to prevent the formation of a space between a battery case and an electrode assembly and such that the accuracy and reliability of the penetration test are improved by inserting a nail to a preset insertion depth of the nail.

### (Prior Art Documents)

(Patent Document 1) Korean Patent Application Publication No. 2023-0006265 (2023.01.10)
(Patent Document 2) Korean Patent Application Publication No. 2023-0061044 (2023.05.08)

### [Disclosure]

### [Technical Problem]

The present invention has been made in view of the above problems, and it is an object of the present invention to provide a penetration test apparatus having a zero-point adjustment device capable of accurately setting the zero point, which is the standard for the insertion depth of a nail, and conducting a test under conditions that satisfy the penetration test standards regardless of a tester, thereby improving reliability of the results thereof, and a penetration test method using the same.

### [Technical Solution]

A penetration test apparatus according to the present invention to accomplish the above object includes an upper surface pressing plate configured to press an upper surface of a battery cell, a lower surface pressing plate configured to press a lower surface of the battery cell, a through-hole in the upper surface pressing plate, a nail configured to penetrate the battery cell through the through-hole, and a zero-point adjustment unit protruding outward from an outer periphery of a side of the upper surface pressing plate.

The penetration test apparatus may further include a resistance measurement unit configured to determine whether the nail and the zero-point adjustment unit are in contact with each other.

The resistance measurement unit may include a first terminal and a second terminal, the first terminal may be connected to the nail, and the second terminal may be connected to the zero-point adjustment unit.

An upper surface of the zero-point adjustment unit may be located on the same plane as a lower surface of the upper surface pressing plate.

An insulating film may be attached to the lower surface of the upper surface pressing plate.

A first area of the zero-point adjustment unit may be attached to the lower surface of the upper surface pressing plate such that an upper surface of the first area of the zero-point adjustment unit overlaps the lower surface of the upper surface pressing plate, and a second area of the zero-point adjustment unit may protrude outward from an outer peripheral surface of the upper surface pressing plate.

The first area of the zero-point adjustment unit may be attached to the lower surface of the upper surface pressing plate via an adhesive member.

The penetration test apparatus may include a pressing force adjustment means for adjusting the magnitude of force with which the battery cell is pressed using the upper surface pressing plate and the lower surface pressing plate.

A penetration test method using the penetration test apparatus includes a first step of fixing a battery cell between an upper surface pressing plate and a lower surface pressing plate, a second step of contacting a nail with a zero-point adjustment unit to set a zero point, and a third step of penetrating the battery cell with the nail.

The first step may be performed as a process of adjusting positions of the upper surface pressing plate and the lower surface pressing plate such that the upper surface pressing plate and the lower surface pressing plate are in tight contact with the battery cell.

The second step may be performed as a process of contacting the nail with an upper surface of the zero-point adjustment unit such that a resistance measured by a resistance measurement unit connected to each of the nail and the zero-point adjustment unit becomes 0 as the zero point.

The process of contacting the nail with the upper surface of the zero-point adjustment unit may be performed twice in succession.

The second step may include a process of moving the nail at a speed of 0.1 mm/s until the nail contacts the zero-point adjustment unit after moving the nail above the zero-point adjustment unit so as to be close to the zero-point adjustment unit.

The third step may include inserting the nail into the battery cell to a set depth value.

In addition, the present invention may provide various combinations of the above solving means.

### [Advantageous Effects]

As is apparent from the above description, a penetration test apparatus according to the present invention includes an upper surface pressing plate and a lower surface pressing plate configured to press a battery cell, whereby the height of the battery cell may be uniform, and an upper surface of an electrode assembly and a battery case of a pouch-shaped battery cell may be in tight contact with each other.

In addition, a zero-point adjustment unit is provided in consideration of the thickness of an insulating film attached to the upper surface pressing plate, whereby the zero point, which starts from the surface of the battery cell and is the reference for the insertion depth of a nail, may be accurately set.

### [Description of Drawings]

FIG. 1 is a perspective view of a conventional penetration test apparatus.
FIG. 2 is a perspective view of a penetration test apparatus according to the present invention.
FIG. 3 is a vertical sectional view taken along line A-A' of FIG. 2.
FIG. 4 is a vertical sectional view showing the state in which a pressing force adjustment means is added to FIG. 3.
FIG. 5 is a plan view of an upper surface pressing plate and a lower surface pressing plate of FIG. 2.
FIG. 6 is a measurement graph of the pressing force based on the insertion depth of a nail during a penetration test according to an example.
FIG. 7 is a measurement graph of the pressing force based on the insertion depth of a nail during a penetration test according to a comparative example.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

The same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

A description to embody elements through limitation or addition may be applied to all inventions, unless particularly restricted, and does not limit a specific invention.

In the description of the invention and the claims of the present application, singular forms are intended to include plural forms unless mentioned otherwise.

In the description of the invention and the claims of the present application, "or" includes "and" unless mentioned otherwise. Therefore, "including A or B" means three cases, namely, the case including A, the case including B, and the case including A and B.

Embodiments of the present invention will be described in more detail with reference to the drawings.

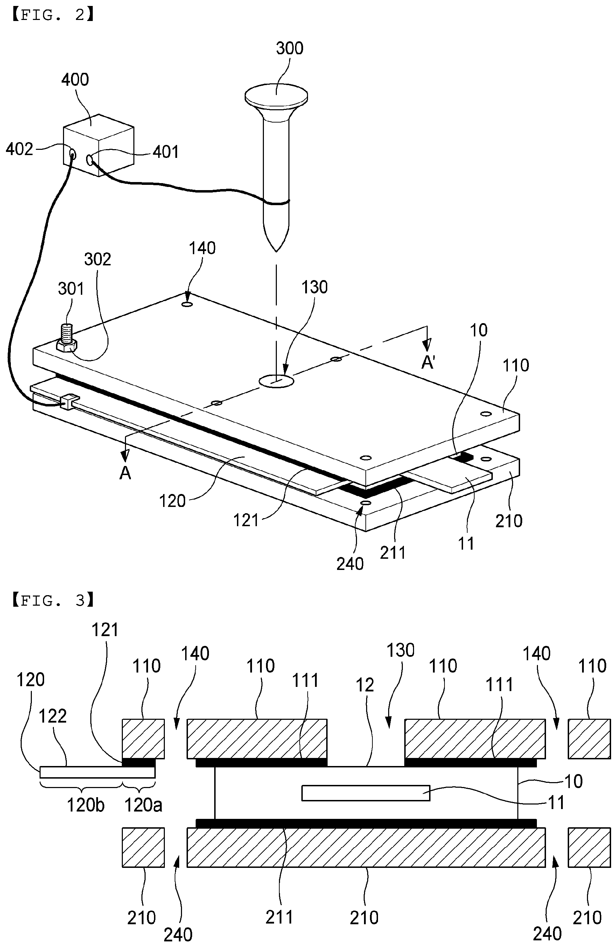

FIG. 2 is a perspective view of a penetration test apparatus according to the present invention, and FIG. 3 is a vertical sectional view taken along line A-A' of FIG. 2.

Referring to FIGs. 2 and 3, the penetration test apparatus according to the present invention includes an upper surface pressing plate 110 configured to press an upper surface of a battery cell 10, a lower surface pressing plate 210 configured to press a lower surface of the battery cell 10, a through-hole 130 provided in the upper surface pressing plate 110, a nail 300 configured to penetrate the battery cell 10 through the through-hole 130, and a zero-point adjustment unit 120 protruding outward from an outer periphery of one side of the upper surface pressing plate 110.

The battery cell 10 may include a prismatic battery cell or a pouch-shaped battery cell, and FIG. 2 shows the state in which the pouch-shaped battery cell is fixed so as to be pressed by the upper surface pressing plate 110 and the lower surface pressing plate 210. The pouch-shaped battery cell may be a bidirectional battery cell in which two electrode leads 11 protrude in opposite directions or a unidirectional battery cell in which two electrode leads protrude in the same direction. The figures show a bidirectional battery cell in which two electrode leads 11 protrude in opposite directions as a non-limiting example.

In the present invention, a penetration test may be conducted by presetting the depth of the nail 300 that is pressed into the battery cell 10 from the surface of the battery cell 10 and checking whether ignition or explosion of the battery cell occurs when the nail is pressed into the battery cell to the preset depth.

Generally, there is a separate device configured to press in the nail, and the pressing-in speed and insertion depth of the nail may be set and controlled using such a device. For example, if the nail is set to penetrate 2.2 mm into the battery cell, the surface of the battery cell must be zeroed, and when the nail is pressed in by the preset 2.2 mm, the nail must actually penetrate the battery cell by 2.2 mm.

If the pressing force of each of the upper surface pressing plate and the lower surface pressing plate that press the battery cell is small, the penetration test may be conducted in the state in which the battery cell is swollen, which may result in the nail not pressing an electrode assembly to the preset insertion depth.

In the present invention, therefore, the zero point is set by providing the zero-point adjustment unit 120 protruding outward from the outer periphery of one side of the upper surface pressing plate 110 and checking the state in which the nail 300 and the zero-point adjustment unit 120 are in contact with each other.

Each of the nail 300 and the zero-point adjustment unit 120 is made of an electrically conductive material, and allows electricity flows when the nail and the zero-point adjustment unit come into contact with each other. To this end, a resistance measurement unit 400 configured to check whether the nail 300 and the zero-point adjustment unit 120 are in contact with each other is included.

The resistance measurement unit 400 includes a first terminal 401 and a second terminal 402. When the first terminal 401 is connected to the nail 300, the second terminal 402 is connected to the zero-point adjustment unit 120, and the nail 300 is brought into contact with the zero-point adjustment unit 120, the resistance measurement unit 400 measures a resistance of less than 5 Ohm, which is similar to 0 Ohm. That is, when the nail 300 is not in contact with the zero-point adjustment unit 120, the resistance measurement unit 400 does not detect any resistance, which effectively means infinite resistance. However, the moment the nail 300 and the zero-point adjustment unit 120 come into contact with each other, electricity flows between the nail 300 and the zero-point adjustment unit 120, and therefore the resistance measurement unit 400 measures a resistance close to 0 Ohm.

In this specification, the resistance value measured when the nail and the zero-point adjustment unit come into contact with each other is described as 0 Ohm.

The zero-point adjustment unit 120 is a means configured to set the state in which the nail 300 is in contact with the surface of the battery cell 10 as the zero point, and an upper surface 122 of the zero-point adjustment unit in which the nail 300 is in contact must be located on the same plane as a lower surface of the upper surface pressing plate 110. Since the lower surface of the upper surface pressing plate 100 may be considered as being located on the same plane as an upper surface 12 of the battery cell, the upper surface 122 of the zero-point adjustment unit may be considered as being located on the same plane as the upper surface 12 of the battery cell.

Generally, since the lower surface of the upper surface pressing plate 110 and an upper surface of the lower surface pressing plate 210 are in direct contact with the battery cell 10, insulating films 111 and 211 are attached for safety. Each of the insulating films 111 and 211 may include an insulating layer made of an insulating material and an adhesive layer provided on one surface of the insulating layer, and the adhesive layer may be attached to a corresponding one of the lower surface of the upper surface pressing plate and the upper surface of the lower surface pressing plate.

The insulating material is not particularly restricted, and any known insulating materials may be used. Each of the insulating films 111 and 211 may be added to the entirety of the surface facing the battery cell 10, but since the zero-point adjustment unit 120 is configured to protrude from the outer periphery of one side of the upper surface pressing plate 110, the insulating film is not attached to the part from which the zero-point adjustment unit 120 protrudes.

The zero-point adjustment unit 120 is configured to protrude from the outer periphery of one side of the upper surface pressing plate 110 such that the contact between the nail 300 and the zero-point adjustment unit is easily visible from the outside, wherein a first area 120a of the zero-point adjustment unit 120 is attached to the lower surface of the upper surface pressing plate 110 such that an upper surface thereof overlaps the lower surface of the upper surface pressing plate, and a second area 120b of the zero-point adjustment unit 120 protrudes outward from an outer peripheral surface of the upper surface pressing plate 110.

The first area 120a of the zero-point adjustment unit 120 is attached to the lower surface of the upper surface pressing plate 110 via an adhesive member 121, and an adhesive or double-sided tape may be used as the adhesive member 121.

Since the position of the upper surface 122 of the zero-point adjustment unit must be corrected by the thickness of the insulating film 111 attached to the lower surface of the upper surface pressing plate 110, it is preferable to attach the adhesive member 121 so as to be interposed between the zero-point adjustment unit 120 and the upper surface pressing plate 110 and to set the thickness of the adhesive member 121 so as to be similar or equal to the thickness of the insulating film 111. However, a micrometer-scale difference may occur between the thickness of the adhesive member 121 and the thickness of the insulating film 111. The difference may be due to the fact that the adhesive layer is added only to one surface of the insulating film 111 and the adhesive layer is added to each surface of the adhesive member 121, but this error may be considered to be a level that does not significantly affect the results of the penetration test. For more precise measurement, the insulating film and the adhesive member may be selected in further consideration of the thickness of the adhesive layer.

Since the upper surface 122 of the zero-point adjustment unit is coupled to the upper surface pressing plate 110 via the adhesive member 121 even when the insulating film 111 is attached to the lower surface of the upper surface pressing plate 110, as described above, the thickness of the insulating film 111 is offset by the thickness of the adhesive member 121 and corrected, and therefore the upper surface 122 of the zero-point adjustment unit may be considered to be located on the same plane as the lower surface of the insulating film 111 attached to the lower surface of the upper surface pressing plate 100. Consequently, the upper surface 122 of the zero-point adjustment unit is located on the same plane as the upper surface 12 of the battery cell.

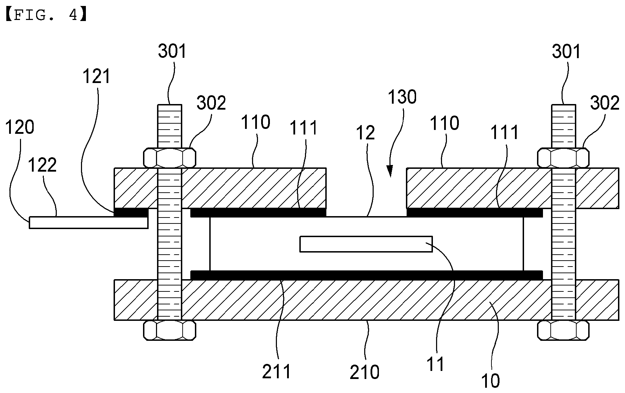

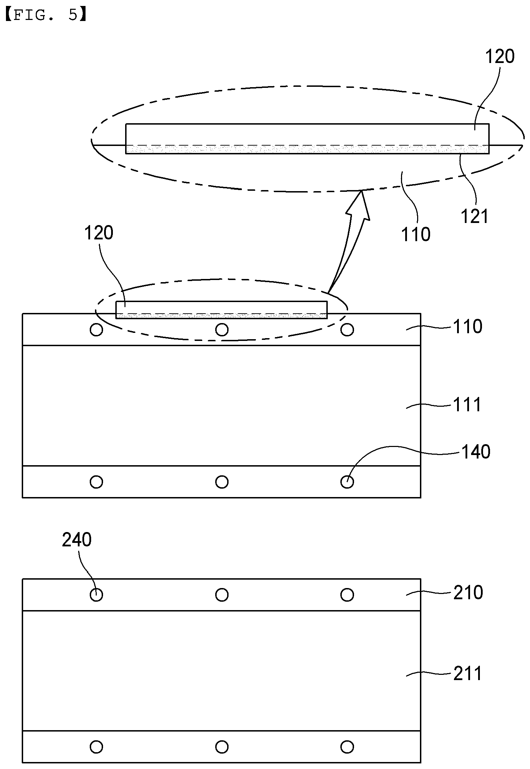

FIG. 4 is a vertical sectional view showing the state in which a pressing force adjustment means is added to FIG. 3, and FIG. 5 is a plan view of the upper surface pressing plate and the lower surface pressing plate of FIG. 2. An enlarged view of FIG. 5 is an enlarged view of the upper surface pressing plate 110, and a plan view of the lower surface pressing plate 210 is shown thereunder.

Referring to FIGs. 4 and 5 in conjunction with FIGs. 2 and 3, a pressing force adjustment means configured to adjust the magnitude of force with which the battery cell 10 is pressed using the upper surface pressing plate 110 and the lower surface pressing plate 210 is included.

In FIGs. 2 and 5, six first fastening holes 140 are formed in the upper surface pressing plate 110, and six second fastening holes 240 are formed in the lower surface pressing plate 210. FIG. 2 shows the state in which a bolt 301 is inserted so as to extend through one of the first fastening holes 140 and one of the second fastening holes 240 and the bolt 301 is fixed using a nut 302.

FIG. 2 is illustrative, and fastening using bolts 301 and nuts 302 is performed for all of the first fastening holes 140 and all of the second fastening holes 240, but the fastening pressure of the bolts must be the same by making the distance between the first fastening hole 140 and the second fastening hole 240 the same at all six positions.

The pressing force adjustment means according to the present invention is not limited to a combination of the bolt 301 and the nut 302, but may include a pressing cylinder attached to each of the upper surface pressing plate and the lower surface pressing plate or a separate pressing member configured to press each of the upper surface pressing plate and the lower surface pressing plate.

However, if the force to press the battery cell is too large or too small, a penetration test that does not match the preset nail insertion depth may be conducted, and therefore it may be necessary to find the optimal pressing condition by pressing the battery cell several times. For example, when the upper surface of the battery cell is flat, not swollen, this may be a properly pressed state, and in consideration of the fact that the pressure to fix the battery cell is typically about 4 kgf when the battery cell is fixed to a jig and a cycle test is performed, the battery cell may be pressed with force greater than this. Specifically, the force to press the battery cell may be 5 kgf to 50 kgf.

If the battery cell is pressed with force less than 5kgf, the battery cell may be too swollen, and therefore even if the nail is pressed in to the preset depth, the actual depth of penetration of the battery cell may be less than the preset depth. When the nail is pressed in, the pressure applied to the nail may also be measured, and if the pressure applied to the nail is found to be less than a reference pressure, it can be seen that the battery cell is in a state of being pressed with force less than 5 kgf.

The fastening pressure may be determined differently for each battery cell, and is determined according to the electrochemical criteria of the battery cell, and therefore qualitative criteria, not quantitative criteria, must be presented.

A penetration test method using a penetration test apparatus according to the present invention includes a first step of fixing a battery cell 10 between an upper surface pressing plate 110 and a lower surface pressing plate 210, a second step of bringing a nail 300 into contact with a zero-point adjustment unit 120 to set the zero point, and a third step of penetrating the battery cell 10 with the nail 300.

The first step may be performed as a process of adjusting the positions of the upper surface pressing plate 110 and the lower surface pressing plate 210 such that the upper surface pressing plate 110 and the lower surface pressing plate 210 are in tight contact with the battery cell 10.

The second step may be performed as a process of bringing the nail 300 into contact with an upper surface of the zero-point adjustment unit 120 to set the position where the resistance of a resistance measurement unit 400 connected to each of the nail 300 and the zero-point adjustment unit 120 becomes 0 Ohm as the zero point.

During a process of setting the zero point, the speed at which the nail 300 is moved downward toward the zero-point adjustment unit 120 is important in order to accurately measure the moment when the nail 300 and the zero-point adjustment unit 120 come into contact with each other and to prevent damage to a tip of the nail 300. For example, when the nail 300 is moved close to the zero-point adjustment unit 120 so as not to reach the zero-point adjustment unit, the nail is moved downward at a speed of 5 mm/s, and when the nail 300 approaches the zero-point adjustment unit 120, the nail is moved downward at a speed of 0.1 mm/s until the nail 300 and the zero-point adjustment unit 120 come into contact with each other while checking the current measurement unit.

At this time, in order to more accurately check the position of the zero point, the process of bringing the nail 300 into contact with the upper surface of the zero-point adjustment unit 120 may be performed twice in succession.

The third step may be performed until the insertion depth of the nail 300 reaches a set value.

In the present invention, as described above, the zero point, which is the surface position of the battery cell, is set using the zero-point adjustment unit in the state in which the battery cell is pressed with an appropriate force, and therefore the penetration test may be conducted accurately to the preset insertion depth. The nail 300 may be provided with a means configured to measure the position of the nail, and therefore, the relative displacement of the nail may be checked after the zero point is set. In addition, the value of the zero point may be checked through the value of a measurement unit provided in the nail 300.

That is, the value of the zero point is checked through the measurement unit provided in the nail 300. After that, the nail 300 is moved upward so as to be spaced apart from the zero-point adjustment unit 120 and is moved horizontally to the position of a through-hole 130. The nail 300 is moved downward at the position of the through-hole 130 until the nail reaches the checked value of the zero point. At this time, the checked value of the zero point may be checked through the measurement unit provided in the nail 300. After that, a practical penetration test is conducted.

Hereinafter, in order to demonstrate how the force with which the upper surface pressing plate and the lower surface pressing plate press the battery cell affects the penetration test of the battery cell when the force is too small and when the force is appropriate, the case of small pressing force will be described as a comparative example, and the case of appropriate pressing force will be described as an example.

The appropriate magnitude of the pressing force is determined by the electrochemical criteria of the battery cell, and in the embodiment of the present invention, 5 kgf to 50 kgf is considered to be an appropriate magnitude, wherein the pressing force is 4 kgf in the comparative example, and the pressing force is 20 kgf in the example.

### <Example>

The penetration test apparatus shown in FIG. 2 was prepared, a pouch-shaped battery cell was disposed between the upper surface pressing plate and the lower surface pressing plate, the pressing force to press the pouch-shaped battery cell was set to 20 kgf, and the pouch-shaped battery cell was pressed using the upper surface pressing plate and the lower surface pressing plate.

The nail was brought into contact with the zero-point adjustment unit to set the zero point on an outer surface of the pouch-shaped battery cell.

The nail was disposed so as to be located at the same position as the zero point through the through-hole of the upper surface pressing plate, and the force with which the nail presses the pouch-shaped battery cell was measured while pressing the nail so as to penetrate the pouch-shaped battery cell by 2.2 mm from the zero point.

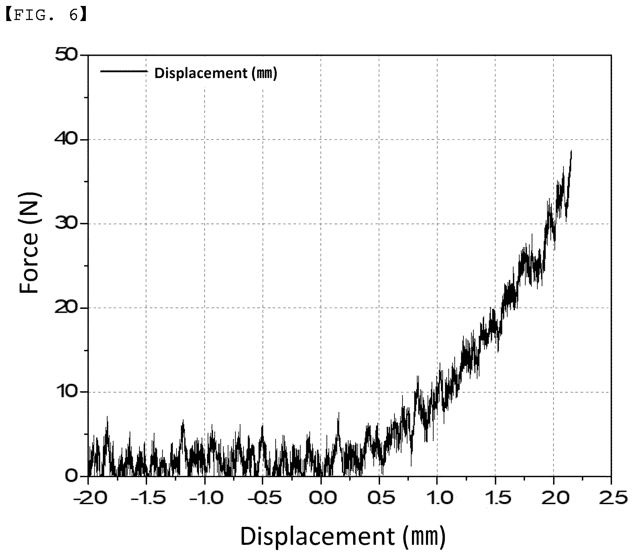

FIG. 6 is a measurement graph of the pressing force based on the insertion depth of the nail during the penetration test according to the example.

### <Comparative example>

A penetration test was conducted in the same manner as in the example, except that the force with which the upper surface pressing plate and the lower surface pressing plate pressed the pouch-shaped battery cell was 4 kgf.

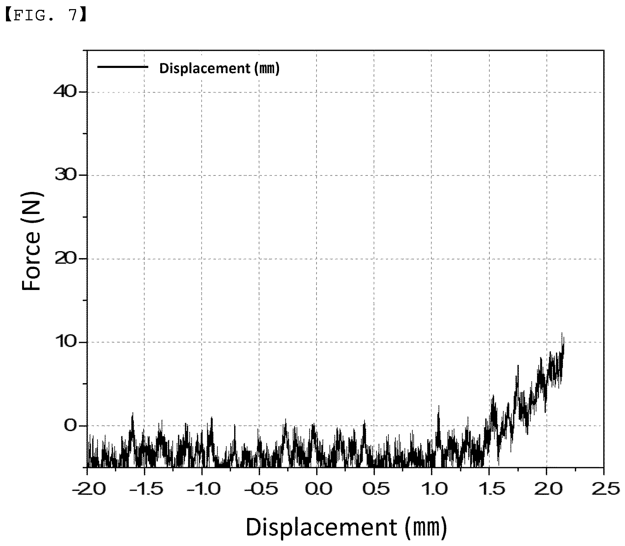

FIG. 7 is a measurement graph of the pressing force based on the insertion depth of the nail during the penetration test according to the comparative example.

Referring to FIGs. 6 and 7, the horizontal axis indicates the distance between the nail and the pouch-shaped battery cell. On the assumption that the zero point, which is the surface of the pouch-shaped battery cell, is 0.0, - indicates before the nail comes into contact with the pouch-shaped battery cell, and values greater than 0.0 indicate the insertion depths of the nail inserted into the pouch-shaped battery cell. The vertical axis indicates the magnitude of the pressing force with which the nail presses the pouch-shaped battery cell.

When the thickness of a battery case is 0.18 mm, the graph of FIG. 6 shows that the pressing force gradually increases from the 0.18 mm point, indicating that the nail has penetrated the electrode assembly of the pouch-shaped battery cell to the preset insertion depth of 2.2 mm. Therefore, it can be seen from the example that the penetration test was conducted in the state in which the upper surface pressing plate and the lower surface pressing plate sufficiently pressed the pouch-shaped battery cell.

The graph of FIG. 7 shows that the force with which the upper surface pressing plate and the lower surface pressing plate press the pouch-shaped battery cell is small and that the pressing force of the nail does not increase when the insertion depth of the nail is 0.0 mm to 1.0 mm and the pressing force increases from the 1.0 mm point. That is, it can be seen that the nail did not penetrate the electrode assembly of the pouch-shaped battery cell when the insertion depth of the nail was 0.0 mm to 1.0 mm.

Therefore, it may be considered that the nail is inserted to the preset insertion depth of the nail only when the penetration test is conducted in the state in which the pouch-shaped battery cell is completely pressed by the upper surface pressing plate and the lower surface pressing plate such that the battery case of the pouch-shaped battery cell is not swollen, in which case reliability in safety assessment of the pouch-shaped battery cell may be guaranteed.

Those skilled in the art to which the present invention pertains will appreciate that various applications and modifications are possible within the scope of the present invention based on the above description.

### (Description of Reference Symbols)

- 10:: Battery cell
- 11:: Electrode lead
- 12:: Upper surface of battery cell
- 20:: Plastic hexahedron
- 110:: Upper surface pressing plate
- 111, 211:: Insulating films
- 120:: Zero-point adjustment unit
- 120a:: First area
- 120b:: Second area
- 121:: Adhesive member
- 122:: Upper surface of zero-point adjustment unit
- 130:: Through-hole
- 140:: First fastening hole
- 210:: Lower surface pressing plate
- 240:: Second fastening hole
- 300:: Nail
- 301:: Bolt
- 302:: Nut
- 400:: Resistance measurement unit
- 401:: First terminal
- 402:: Second terminal

## Claims

1. A penetration test apparatus comprising:
an upper surface pressing plate configured to press an upper surface of a battery cell;
a lower surface pressing plate configured to press a lower surface of the battery cell;
a through-hole in the upper surface pressing plate;
a nail configured to penetrate the battery cell through the through-hole; and
a zero-point adjustment unit protruding outward from an outer periphery of a side of the upper surface pressing plate.

2. The penetration test apparatus according to claim 1, further comprising a resistance measurement unit configured to determine whether the nail and the zero-point adjustment unit are in contact with each other.

3. The penetration test apparatus according to claim 2, wherein
the resistance measurement unit comprises a first terminal and a second terminal,
the first terminal is connected to the nail, and
the second terminal is connected to the zero-point adjustment unit.

4. The penetration test apparatus according to claim 1, wherein an upper surface of the zero-point adjustment unit is located on the same plane as a lower surface of the upper surface pressing plate.

5. The penetration test apparatus according to claim 1, wherein an insulating film is attached to a lower surface of the upper surface pressing plate.

6. The penetration test apparatus according to claim 1, wherein
a first area of the zero-point adjustment unit is attached to a lower surface of the upper surface pressing plate such that an upper surface of the first area of the zero-point adjustment unit overlaps the lower surface of the upper surface pressing plate, and
a second area of the zero-point adjustment unit protrudes outward from an outer peripheral surface of the upper surface pressing plate.

7. The penetration test apparatus according to claim 6, wherein the first area of the zero-point adjustment unit is attached to the lower surface of the upper surface pressing plate via an adhesive member.

8. The penetration test apparatus according to claim 1, comprising a pressing force adjustment means for adjusting a magnitude of force with which the battery cell is pressed using the upper surface pressing plate and the lower surface pressing plate.

9. A penetration test method using the penetration test apparatus according to any one of claims 1 to 8, the penetration test method comprising:
a first step of fixing a battery cell between an upper surface pressing plate and a lower surface pressing plate;
a second step of contacting a nail with a zero-point adjustment unit to set a zero point; and
a third step of penetrating the battery cell with the nail.

10. The penetration test method according to claim 9, wherein the first step is performed as a process of adjusting positions of the upper surface pressing plate and the lower surface pressing plate such that the upper surface pressing plate and the lower surface pressing plate are in tight contact with the battery cell.

11. The penetration test method according to claim 9, wherein the second step is performed as a process of contacting the nail with an upper surface of the zero-point adjustment unit such that a resistance measured by a resistance measurement unit connected to each of the nail and the zero-point adjustment unit becomes 0 as the zero point.

12. The penetration test method according to claim 11, wherein the process of contacting the nail with the upper surface of the zero-point adjustment unit is performed twice in succession.

13. The penetration test method according to claim 11, wherein the second step comprises a process of moving the nail at a speed of 0.1 mm/s until the nail contacts the zero-point adjustment unit after moving the nail above the zero-point adjustment unit so as to be close to the zero-point adjustment unit.

14. The penetration test method according to claim 9, wherein the third step comprises inserting the nail into the battery cell to a set depth value.
